# EUROPÄISCHE PATENTSCHRIFT

(11) **EP 2 433 149 B1**
(45) Veröffentlichungstag und Bekanntmachung des Hinweises auf die Patenterteilung: **24.04.2019**
(21) Anmeldenummer: 10721732.5
(22) Anmeldetag: 03.05.2010
(51) Int. Cl.: F03D 7/02, H02P 3/04

(54) **VERFAHREN ZUM ÜBERPRÜFEN EINES ELEKTRISCHEN ENERGIESPEICHERS**
METHOD FOR EXAMINING AN ELECTRIC ENERGY ACCUMULATOR
PROCÉDÉ DE VÉRIFICATION D'UN ACCUMULATEUR D'ÉNERGIE ÉLECTRIQUE

(30) Priorität: 17.05.2009 DE 102009025819
(43) Veröffentlichungstag der Anmeldung: 28.03.2012
(73) Patentinhaber: Nidec SSB Wind Systems GmbH, 48499 Salzbergen (DE)
(72) Erfinder: KESTERMANN, Hermann, 48432 Rheine (DE)
(74) Vertreter: Bossmeyer, Jörg Peter
(86) Internationale Anmeldenummer: PCT/EP2010/055984
(87) Internationale Veröffentlichungsnummer: WO 2010/133444

(56) Entgegenhaltungen:
- EP-A2- 1 852 605
- EP-A2- 2 058 513
- EP-A2- 2 313 792
- DE-A1-102006 009 127
- DE-U1- 29 722 109

## Beschreibung

Die Erfindung betrifft ein Verfahren zum Überprüfen eines elektrischen Energiespeichers für einen Blattwinkelverstellantrieb einer Windkraftanlage, der einen Umrichter, wenigstens einen von dem Umrichter gespeisten Elektromotor und den Energiespeicher umfasst. Ferner betrifft die Erfindung einen Blattwinkelverstellantrieb für eine Windkraftanlage.

In einer Windkraftanlage wird für die Versorgung des Blattwinkelverstellsystems (Pitch-System) bei Netzspannungsausfall ein elektrischer Energiespeicher (Backup-Spannungsquelle) in Form wenigstens eines Akkumulators (Batterie) und/oder Hochleistungskondensators eingesetzt. Die Verfügbarkeit des Energiespeichers ist von entscheidender Bedeutung für die Sicherheit der Windkraftanlage. Somit ist es wichtig, die verfügbare Kapazität des Energiespeichers zu überwachen, da diese durch Alterung oder sonstige Einflüsse geringer werden kann.

Die Überwachung der Kapazität erfolgt beispielsweise durch zusätzliche Entladewiderstände, die über Schaltgeräte (z.B. Schütz) mit dem Energiespeicher verbunden werden. Danach wird eine Teilentladung des Energiespeichers durchgeführt und der Verlauf des entnommenen Stroms und der Batterie- / Kondensatorspannung mittels Messumformer gemessen. Eine weitere Möglichkeit zur Überwachung der Kapazität bietet ein Batterie-Managementsystem, das alle Ströme in die Batterie sowie die Entnahmeströme misst, die Umgebungsbedingungen aufzeichnet und so rechnerisch die Restkapazität ermittelt.

Die DE 10 2005 030 709 A1 offenbart einen Stellantrieb für ein Rotorblatt einer Windkraftanlage mit einem elektrischen Motor und mit einem Frequenzumrichter, der einen aus einem Stromnetz zu speisenden Gleichrichter, einen an den Gleichrichter angeschlossenen Zwischenkreis, und einen Wechselrichter zum Speisen des Motors aufweist, wobei der Zwischenkreis in einem netzgespeisten Normalbetrieb des Frequenzumrichters eine vorgegebene Nennbetriebsspannung führt. Der Stellantrieb weist ferner eine an den Zwischenkreis angeschlossene Notenergieversorgungseinrichtung, die einen eine elektrische Stützspannung bereitstellenden Energiespeicher umfasst, und eine zwischen den Energiespeicher und den Zwischenkreis geschaltete Diode auf, die hinsichtlich ihrer Durchlassrichtung so angeordnet ist, dass sie einen Stützstrom aus dem Energiespeicher in den Zwischenkreis speist, falls die Zwischenkreisspannung unter die Stützspannung fällt. Der Energiespeicher weist eine Serienschaltung von Akkumulatoreinheiten auf, wobei durch einen Entladevorgang über einen bekannten Widerstand unter anderem aus der Akkumulatorspannung der Innenwiderstand jeder Akkumulatoreinheit bestimmt werden kann.

Diese Schaltung weist den Nachteil auf, dass zum Überprüfen der Akkumulatoreinheiten zusätzliche Bauelemente erforderlich sind, die zu einer Kostenerhöhung des Stellantriebs beitragen.

Die frühere Anmeldung EP 2313792 A0 offenbart den Oberbegriff des Anspruchs 1; d.h. eine Blattverstellung bei der der Energiespeicher durch Blockieren des Antriebs geprüft wird.

Die Druckschrift EP 2058513 A2 zeigt einen Mechanismus zur Blattverstellung, der durch gelegentliches Anfahren der Fahnenposition getestet wird. Ein Rückschluss auf die Batterie durch Blockieren des Antriebs wird nicht vollzogen. 1

Die EP 1852605 A2 behandelt eine Schaltung, welche dazu vorgesehen ist, eine generatorisch erzeugte Leistung zu vernichten, sofern der Pitchantrieb als Generator arbeitet. Diese Schaltung kann auch zum Test der Batterie verwendet werden.

Ausgehend hiervon liegt der Erfindung die Aufgabe zugrunde, eine kostengünstigere Möglichkeit zur Überprüfung des Energiespeichers zu schaffen.

Diese Aufgabe wird erfindungsgemäß durch ein Verfahren nach Anspruch 1 und durch einen Blattwinkelverstellantrieb nach Anspruch 13 gelöst. Bevorzugte Weiterbildungen der Erfindung sind in den Unteransprüchen gegeben.

Das erfindungsgemäße Verfahren zum Überprüfen eines elektrischen Energiespeichers für einen Blattwinkelverstellantrieb einer Windkraftanlage, der einen Umrichter, wenigstens einen von dem Umrichter gespeisten Elektromotor und den Energiespeicher umfasst, weist die Verfahrensschritte auf:
- Blockieren des Elektromotors,
- Belasten des Energiespeichers mit dem blockierten Elektromotor über den Umrichter,
- Beobachten der Entladung des mit dem blockierten Elektromotor belasteten Energiespeichers.

Das erfindungsgemäße Verfahren nutzt den bereits in der Windkraftanlage vorhandenen Elektromotor als elektrische Last zur Entladung des Energiespeichers, sodass ein zusätzlicher Entladewiderstand mit zugehörigen Beschaltungselementen entfallen kann. Ferner wird zum Blockieren des Elektromotors bevorzugt eine in der Windkraftanlage und/oder an dem Elektromotor bereits vorhandene Bremse eingesetzt, sodass auch hierfür keine zusätzlichen Bauelemente erforderlich sind. Das Blockieren des Elektromotors erfolgt bevorzugt mechanisch oder elektromechanisch.

Zur Implementierung des erfindungsgemäßen Verfahrens wird vorzugsweise eine Steuereinheit eingesetzt, die insbesondere einen Digitalrechner umfasst. Da bevorzugt eine solche Steuereinheit bereits in der Windkraftanlage und/oder dem Umrichter vorhanden ist, kann das erfindungsgemäße Verfahren mit einer Änderung oder Ergänzung des in der Steuereinheit ablaufenden Programms (Software) realisiert werden. Somit bietet das erfindungsgemäße Verfahren einen deutlichen Kostenvorteil gegenüber einer herkömmlichen Lösung mit separatem Entladewiderstand. Die Steuereinheit kann extern von dem Umrichter vorgesehen sein. Bevorzugt bildet die Steuereinheit aber einen Teil des Umrichters und/oder ist in diesen integriert.

Alternativ zur Erfindung wäre es denkbar, den Elektromotor während der Entladung ungebremst oder gebremst laufen zu lassen. In diesem Fall könnte aber der laufende Elektromotor, der Wind und/oder die mechanische Kopplung des Elektromotors mit dem Rotorblatt die durch den Elektromotor gebildete Last während der Entladung des Energiespeichers beeinflussen, was zur Ermittlung eines fehlerhaften Zustands des Energiespeichers führen könnte. Deshalb wird bei dem erfindungsgemäßen Verfahren der Elektromotor während der Belastung des Energiespeichers blockiert, sodass die durch den Elektromotor gebildete Last konstant oder im Wesentlichen konstant ist. Somit kann aus der Beobachtung der Entladung eine aussagekräftige Beschreibung des Zustands des Energiespeichers gewonnen werden.

Durch die Belastung des Energiespeichers mit dem blockierten Elektromotor wird bevorzugt eine Teilentladung des Energiespeichers durchgeführt. Alternativ kann der Energiespeicher durch die Belastung aber auch vollständig entladen werden.

Bevorzugt ist der Energiespeicher während der Belastung elektrisch auf einen Zwischenkreis des Umrichters geschaltet. Beispielsweise wird der Energiespeicher vor oder zu Beginn seiner Belastung mit dem blockierten Elektromotor elektrisch auf den Zwischenkreis geschaltet. Dies ist insbesondere dann sinnvoll, wenn der Energiespeicher im Normalbetrieb des Blattwinkelverstellantriebs nicht auf den Zwischenkreis geschaltet ist. Alternativ ist der Energiespeicher dauerhaft, d.h. auch im Normalbetrieb des Blattwinkelverstellantriebs, elektrisch auf den Zwischenkreis geschaltet. Dabei ist oder wird der Energiespeicher bevorzugt unter Zwischenschaltung wenigstens einer Diode elektrisch auf den Zwischenkreis geschaltet, sodass Rückwirkungen des Zwischenkreises auf den Energiespeicher verhindert werden können. Der Zwischenkreis ist insbesondere ein Gleichspannungszwischenkreis.

Zum Laden des Energiespeichers ist z.B. ein Ladegerät vorgesehen, welches elektrisch mit dem Energiespeicher verbunden oder verbindbar ist. Alternativ kann der Energiespeicher über den Zwischenkreis geladen werden. In diesem Fall wird die Diode zum Laden des Energiespeichers vorzugsweise überbrückt.

Der Umrichter wird, insbesondere im Normalbetrieb, von einer Primär-Energieversorgung mit elektrischer Energie versorgt. Die Primär-Energieversorgung ist bevorzugt ein elektrisches Netz, insbesondere ein internes Windkraftanlagennetz oder ein externes Netz, wie z.B. das allgemeine Stromversorgungsnetz. Bei dem Netz handelt es sich um ein Gleichstromnetz oder um ein Wechselstromnetz, insbesondere um ein Drehstromnetz.

Der Umrichter und/oder der Zwischenkreis wird vorzugsweise vor oder zu Beginn der Belastung des Energiespeichers mit dem blockierten Elektromotor von der Primär-Energieversorgung getrennt. Insbesondere ist oder wird der Umrichter und/oder der Zwischenkreis während der Belastung des Energiespeichers von der Primär-Energieversorgung elektrisch getrennt. Hierdurch ist eine Beeinflussung der Entladung des Energiespeichers durch die Primär-Energieversorgung vermeidbar. Insbesondere entspricht die Zwischenkreisspannung des Umrichters der oder annähernd der Spannung des Energiespeichers.

Während der Belastung des Energiespeichers mit dem blockierten Elektromotor fließt durch den Elektromotor ein elektrischer Motorstrom. Das Beobachten der Entladung des Energiespeichers umfasst bevorzugt das Messen des elektrischen Motorstroms. Insbesondere wird der elektrische Motorstrom während der Belastung des Energiespeichers von dem Umrichter gesteuert oder geregelt. Vorzugsweise wird der elektrische Motorstrom während der Belastung des Energiespeichers von dem Umrichter konstant gehalten, wobei der konstante Strom bevorzugt kleiner oder gleich dem Nennstrom des Elektromotors ist. Alternativ wird der Motorstrom während der Belastung des Energiespeichers von dem Umrichter lediglich kleiner oder gleich einem Schwellenwert gehalten, der vorzugsweise dem Nennstrom des Elektromotors entspricht. Zum Messen des Motorstroms ist eine Strommesseinrichtung vorgesehen, mittels welcher der Motorstrom gemessen werden kann. Bevorzugt ist diese Messeinrichtung bereits in dem Blattwinkelverstellantrieb vorhanden, sodass zum Messen des Motorstroms keine zusätzlichen Bauelemente erforderlich sind. Das Messen des Motorstroms wird während der Entladung des Energiespeichers insbesondere kontinuierlich, quasikontinuierlich oder zumindest mehrfach durchgeführt, sodass ein zeitlicher Verlauf des Motorstroms erfasst wird. Gemäß einer Alternative kann das Beobachten der Entladung des Energiespeichers aber auch das Messen des aus dem und/oder in den Energiespeicher fließenden Stroms umfassen.

Bevorzugt umfasst das Beobachten der Entladung des Energiespeichers, vorzugsweise zusätzlich zur Strommessung, das Messen der Zwischenkreisspannung. Zum Messen der Zwischenkreisspannung ist eine Spannungsmesseinrichtung vorgesehen, mittels welcher die Zwischenkreisspannung gemessen werden kann. Bevorzugt ist diese Messeinrichtung bereits in dem Blattwinkelverstellantrieb vorhanden, sodass zum Messen der Zwischenkreisspannung keine zusätzlichen Bauelemente erforderlich sind. Das Messen der Zwischenkreisspannung wird während der Entladung des Energiespeichers insbesondere kontinuierlich, quasikontinuierlich oder zumindest mehrfach durchgeführt, sodass ein zeitlicher Verlauf der Zwischenkreisspannung erfasst wird. Gemäß einer Alternative kann das Beobachten der Entladung des Energiespeichers aber auch das Messen der Motorspannung umfassen.

Auf Basis der Beobachtung der Entladung des Energiespeichers wird bevorzugt wenigstens ein Zustand des Energiespeichers bestimmt. Insbesondere wird auf Basis der Beobachtung der Entladung des Energiespeichers die in dem Energiespeicher speicherbare Ladungsmenge und/oder der Ladezustand des Energiespeichers bestimmt. Bei der speicherbaren Ladungsmenge handelt es sich insbesondere um die maximal in dem Energiespeicher speicherbare Ladungsmenge.

Der Energiespeicher ist oder bildet bevorzugt eine Gleichstromquelle. Gemäß einer Ausgestaltung der Erfindung umfasst der Energiespeicher wenigstens einen Akkumulator oder ist durch diesen gebildet. Die in dem Akkumulator maximal speicherbare Ladungsmenge wird auch als Kapazität des Akkumulators bezeichnet. Ergänzend oder alternativ umfasst der Energiespeicher bevorzugt wenigstens einen Kondensator oder ist durch diesen gebildet. In diesem Fall wird auf Basis der Beobachtung der Entladung des Energiespeichers bevorzugt die elektrische Kapazität des Kondensators bestimmt. Diese Kapazität, die üblicherweise in Farad (F) angegeben wird, ist von der Kapazität des Akkumulators zu unterscheiden, die üblicherweise in Amperestunden (Ah) angegeben wird. Der Energiespeicher umfasst somit vorzugsweise wenigstens einen Akkumulator und/oder wenigstens einen Kondensator.

Gemäß einer Weiterbildung der Erfindung ist der Akkumulator aus einer oder mehreren Akkumulatoreinheiten zusammengesetzt, die insbesondere in Reihe geschaltet sind. Ergänzend oder alternativ umfasst der Kondensator bevorzugt eine oder mehrere Kondensatoreinheiten, die insbesondere in Reihe geschaltet sind. Die Reihenschaltung der Einheiten dient vorzugsweise dazu, die Spannung des Energiespeichers zu erhöhen. Alternativ ist aber auch eine Parallelschaltung oder eine Kombination aus Reihenschaltung und Parallelschaltung der Einheiten möglich, sodass der von dem Energiespeicher lieferbare, maximale Strom erhöht werden kann. Umfasst der Energiespeicher wenigstens einen Akkumulator, so wird auf Basis der Beobachtung der Entladung des Energiespeichers vorzugsweise der Gesundheitszustand (engl.: state of health = SOH) und/oder der Ladezustand (engl.: state of charge = SOC) des Akkumulators bestimmt.

Das Beobachten der Entladung des Energiespeichers erfolgt bevorzugt mittels der Steuereinheit. Das Bestimmen des oder der Zustände des Energiespeichers, insbesondere das Bestimmen der speicherbaren Ladungsmenge, der Kapazität und/oder des Ladezustands erfolgt bevorzugt mittels einer Auswerteeinheit. Die Auswerteeinheit kann extern von dem Umrichter vorgesehen sein. Bevorzugt bildet die Auswerteeinheit aber einen Teil des Umrichters und/oder ist in diesen integriert.

Gemäß einer Ausgestaltung der Erfindung ist die Auswerteeinheit ganz oder teilweise durch die Steuereinheit gebildet und/oder in diese integriert. Gemäß einer alternativen Ausgestaltung der Erfindung ist die Auswerteeinheit zusätzlich zu der Steuereinheit vorgesehen. In diesem Fall ist die Auswerteeinheit vorzugsweise mit der Steuereinheit gekoppelt, sodass z.B. ein Signal- und/oder Datenaustausch zwischen der Steuereinheit und der Auswerteeinheit erfolgen kann.

Bevorzugt ist die Auswerteeinheit mit einer Steuerung elektrisch gekoppelt, die z.B. die Steuerung der Windkraftanlage bildet. Insbesondere gibt die Auswerteeinheit die Ergebnisse der Auswertung, wie z.B. die speicherbare Ladungsmenge, die Kapazität und/oder den Ladezustand, an die Steuerung ab. Ist die Auswerteeinheit zusätzlich zu der Steuereinheit vorgesehen, so kann die Auswerteeinheit auch durch die Steuerung gebildet sein. Mittels der Steuerung ist z.B. die Steuereinheit und/oder der Umrichter ansteuerbar.

Der Energiespeicher dient insbesondere zur elektrischen Notstromversorgung des Elektromotors, sodass dieser während eines Ausfalls der Primär-Energieversorgung vorübergehend weiterbetrieben werden und/oder eine Notausfahrt durchführen kann. Unter einer Notausfahrt ist zu verstehen, dass ein mit dem Elektromotor gekoppeltes Rotorblatt der Windkraftanlage in eine sichere Position gestellt oder gedreht wird, in welcher der Wind vorzugsweise keine oder lediglich eine geringe Kraft auf das Rotorblatt und/oder auf den dieses umfassenden Rotor der Windkraftanlage ausübt. Die sichere Position ist insbesondere die sogenannte Fahnenstellung des Rotorblatts. Im Falle eines Ausfalls der Primär-Energieversorgung wird der Elektromotor bevorzugt von dem Energiespeicher mit elektrischer Energie versorgt, insbesondere über den Umrichter.

Das erfindungsgemäße Verfahren dient zum Überprüfen des Energiespeichers, sodass die Belastung des Energiespeichers mit dem blockierten Elektromotor bevorzugt nur vorübergehend erfolgt. Insbesondere wird die Blockade des Elektromotors nach der Belastung des Energiespeichers mit dem blockierten Elektromotor aufgehoben. Die Dauer, für die der Elektromotor blockiert und die Belastung des Energiespeichers beobachtet werden, kann von der Kapazität des Energiespeichers abhängen. Gemäß einer Ausgestaltung der Erfindung beträgt die Dauer mehrere Sekunden, z.B. 10 Sekunden. Gemäß einer anderen Ausgestaltung der Erfindung beträgt die Dauer eine oder mehrere Minuten, z.B. 10 Minuten. Es sind aber auch kürzere oder längere Dauern möglich. Insbesondere sind die Zahlenangaben zu der Dauer lediglich beispielhaft und nicht einschränkend zu verstehen. Bevorzugt wird die Überprüfung des Energiespeichers bei Windstille oder bei schwachem Wind durchgeführt. Ferner kann der Energiespeicher überprüft werden, wenn die Windkraftanlage zu Wartungs- und/oder Prüfzwecken heruntergefahren ist.

Die Erfindung betrifft ferner einen Blattwinkelverstellantrieb für eine Windkraftanlage, mit einem einen Gleichspannungszwischenkreis aufweisenden Umrichter, der elektrisch von einer Primär-Energieversorgung gespeist wird oder werden kann, wenigstens einem mit dem Umrichter elektrisch gekoppelten Elektromotor, der von dem Umrichter mit elektrischer Energie versorgt wird oder werden kann, und einem Energiespeicher, von welchem der Elektromotor bei Ausfall der Primär-Energieversorgung elektrisch gespeist wird oder werden kann. Der Blattwinkelverstellantrieb ist insbesondere derart weitergebildet, dass
der Elektromotor mittels einer Bremse blockiert wird oder werden kann,
der Umrichter und/oder der Zwischenkreis von der Primär-Energieversorgung elektrisch getrennt wird oder werden kann, bei getrennter Primär-Energieversorgung der Energiespeicher über den Umrichter mit dem durch die Bremse blockierten Elektromotor elektrisch belastet wird oder werden kann, und die Entladung des mit dem blockierten Elektromotor belasteten Energiespeichers beobachtet wird oder werden kann. Der Energiespeicher ist insbesondere elektrisch auf den Zwischenkreis geschaltet oder schaltbar.

Das erfindungsgemäße Verfahren wird insbesondere mit dem erfindungsgemäßen Blattwinkelverstellantrieb durchgeführt. Somit kann der Blattwinkelverstellantrieb gemäß allen im Zusammenhang mit dem Verfahren beschriebenen Ausgestaltungen weitergebildet sein. Ferner kann das erfindungsgemäße Verfahren gemäß allen im Zusammenhang mit dem Blattwinkelverstellantrieb beschriebenen Ausgestaltungen weitergebildet sein.

Der Blattwinkelverstellantrieb weist bevorzugt eine Steuereinheit auf, mittels welcher die Bremse betätigt wird oder werden kann, die Primär-Energieversorgung elektrisch von dem Zwischenkreis entkoppelt wird oder werden kann und/oder die Entladung des mit dem blockierten Elektromotor belasteten Energiespeichers beobachtet wird oder werden kann.

Die Steuereinheit umfasst bevorzugt eine Strommesseinrichtung, mittels welcher der Motorstrom gemessen wird oder werden kann. Das Messen des Motorstroms ist mittels der Steuereinheit insbesondere kontinuierlich, quasikontinuierlich oder zumindest mehrfach durchführbar, sodass ein zeitlicher Verlauf des Motorstroms erfasst werden kann. Ferner umfasst die Steuereinheit bevorzugt eine Spannungsmesseinrichtung, mittels welcher die Zwischenkreisspannung gemessen wird oder werden kann. Das Messen der Zwischenkreisspannung ist mittels der Steuereinheit insbesondere kontinuierlich, quasikontinuierlich oder zumindest mehrfach durchführbar, sodass ein zeitlicher Verlauf der Zwischenkreisspannung erfasst werden kann.

Zum Erfassen des zeitlichen Verlaufs des Motorstroms und/oder der Zwischenkreisspannung umfasst die Steuereinheit bevorzugt einen Zeit- oder Taktgeber, wie z.B. eine Uhr. Die Steuereinheit weist insbesondere einen Digitalrechner auf.

Der Umrichter umfasst bevorzugt einen Gleichrichter und eine Ausgangsstufe, deren Eingang vorzugsweise unter Zwischenschaltung des Zwischenkreises mit dem Ausgang des Gleichrichters elektrisch gekoppelt ist. Die Ausgangsstufe ist mit ihrem Ausgang vorzugsweise mit dem Elektromotor elektrisch gekoppelt und insbesondere mittels der Steuereinheit zum Steuern des Motorstroms ansteuerbar. Der Gleichrichter ist mit seinem Eingang bevorzugt mit der Primär-Energieversorgung gekoppelt oder koppelbar.

Gemäß einer Ausgestaltung der Erfindung ist zwischen der Primär-Energieversorgung und dem Umrichter oder dem Zwischenkreis wenigstens ein Schalter vorgesehen, mittels welchem der Umrichter und/oder der Zwischenkreis von der Primär-Energieversorgung elektrisch entkoppelt werden kann. Der Schalter ist insbesondere mittels der Steuereinheit betätigbar. Ergänzend oder alternativ ist der Gleichrichter als aktivierbarer Gleichrichter ausgebildet, was z.B. dadurch realisiert werden kann, dass der Gleichrichter schaltbare, stromrichtende Bauelemente, wie z.B. Thyristoren, aufweist. In diesem Fall kann der Schalter zum Entkoppeln der Primär-Energieversorgung entfallen, da eine elektrische Entkopplung des Zwischenkreises von der Primär-Energieversorgung durch die schaltbaren, stromrichtenden Bauelemente erzielt werden kann. Der aktivierbare Gleichrichter ist insbesondere mittels der Steuereinheit steuerbar, insbesondere aktivierbar und deaktivierbar.

Der Elektromotor kann als Gleichstrommotor oder als Wechselstrommotor ausgebildet sein. Die Ausgangsstufe ist bevorzugt als Wechselrichter ausgebildet, wenn der Elektromotor ein Wechselstrommotor ist. Handelt es sich bei dem Elektromotor hingegen um einen Gleichstrommotor, so ist die Ausgangsstufe bevorzugt als steuerbare Gleichstromquelle, wie z.B. als Pulsweitenmodulator oder als Gleichstromsteller ausgebildet. Die Ausgangsstufe ist vorzugsweise eine Transistorausgangsstufe, die insbesondere mit IGBTs aufgebaut ist. Eine solche Ausgangsstufe kann sowohl für einen Gleichstrommotor als auch für einen Wechselstrommotor verwendet werden.

Die Bremse ist bevorzugt eine mechanische Bremse, die insbesondere den Läufer des Elektromotors bremst oder bremsen kann. Die Bremse weist z.B. ein Reibelement und eine Feder auf, welche das Reibelement gegen den Läufer oder gegen ein mit dem Läufer drehfest verbundenes Bauteil, wie z.B. die Motorwelle oder eine Bremsscheibe, drückt. Bevorzugt ist ein Elektromagnet vorgesehen, mittels welchem das Reibelement gegen die Kraft der Feder magnetisch von dem Läufer oder dem Bauteil abgerückt werden kann. Vorzugsweise besteht das Reibelement dazu zumindest teilweise aus Magnetwerkstoff. Bei einem Ausfall der Primär-Energieversorgung bricht das magnetische Feld des Elektromagneten zusammen, sodass das Reibelement automatisch durch die Feder gegen den Läufer oder das Bauteil gedrückt wird. Die Bremse ist insbesondere derart ausgelegt, dass sie den Elektromotor blockieren kann, auch wenn dieser mit einem Strom, wie z.B. mit dem Nennstrom oder mit einem größeren Strom, beaufschlagt wird.

Der Elektromotor ist bevorzugt mit einem Rotorblatt der Windkraftanlage verbunden, insbesondere mechanisch verbunden, z.B. unter Zwischenschaltung eines Getriebes. Bevorzugt kann das Rotorblatt durch den Elektromotor um eine Blattachse gedreht werden.

Gemäß einer Ausgestaltung der Erfindung kann somit bei Betrieb des Blattwinkelverstellantriebs unter Verwendung eines Zwischenkreisumrichters in Phasen, in denen der Blattwinkelverstellantrieb nicht aktiv ist, durch eine in den Umrichter integrierte Software ein Kapazitätstest des Energiespeichers (Akkumulator/Kondensator) durchgeführt werden. Hierzu wird der Energiespeicher, der im normalen Betriebszustand mit dem Zwischenkreis des Umrichters verbunden ist, über den Transistorausgang des Umrichters mit dem Elektromotor, der dann als Belastung dient, verbunden. Die Spannungsversorgung des Umrichters aus dem Netz (Primär-Energieversorgung) wird für diesen Test abgeschaltet, sodass die Höhe der Zwischenkreisspannung der Höhe der Spannung des Energiespeichers entspricht. Als weitere Größe kann der Strom in den zur Belastung dienenden Elektromotor über die integrierte Stromerfassung des Umrichters erfasst werden. Zeiten können über die integrierte Echtzeituhr des Umrichters gesteuert werden. Der Umrichter prägt einen Strom in den Motor ein, wobei sich aus der Entladekurve des Energiespeichers genauere Aussagen über die Kapazität ermitteln bzw. berechnen lassen. Der Motor ist in diesem Zustand über die eingebaute Bremse blockiert, sodass keine Beeinflussung des Messergebnisses durch einen sich drehenden Motor auftritt. Wird der Strom aus dem Energiespeicher auf Werte unterhalb des Nennstroms des Elektromotors begrenzt, kann eine thermische Überlastung des Motors in der Regel nicht auftreten. Dennoch wird die Motortemperatur überwacht, damit der Test (Überprüfung) nicht durchgeführt wird oder werden kann, wenn die Motortemperatur durch eine vorhergehende Belastung des Motors über einem Schwellenwert liegt.

Die Ausgabe oder Kommunikation der Messergebnisse kann über die zum Datenaustausch bereits vorhandenen seriellen Schnittstellen der Steuereinheit erfolgen, oder auch, z.B. bei Unterschreitung einer Mindestkapazität, als digitales oder analoges Signal über andere Schnittstellen der Steuereinheit.

Durch die Erfindung kann ohne oder mit nur geringfügigem zusätzlichen Aufwand bzw. Kosten mit in der Windkraftanlage bereits vorhandenen Geräten eine verlässliche Aussage über die aktuell vorhandene Kapazität des Energiespeichers getroffen werden. Diese Aussage ist besonders hilfreich bei der Planung der regelmäßigen Wartung, bei der die Ermittlung der Energiespeicher mit zu geringer Kapazität ohne separat notwendigen Einsatz erfolgen kann. Ferner kann die Zuverlässigkeit des Sicherheitssystems der Windkraftanlage erhöht werden.

Die Erfindung wird nachfolgend anhand einer bevorzugten Ausführungsform unter Bezugnahme auf die Zeichnung beschrieben. In der Zeichnung zeigen:
- Fig. 1:: eine schematische Darstellung einer Windkraftanlage,
- Fig. 2: eine schematische Draufsicht auf den Rotor der Windkraftanlage,
- Fig. 3:: ein schematisches Blockschaltbild eines Blattwinkelverstellantriebs,
- Fig. 4:: ein schematisches Schaltbild des Umrichters und
- Fig. 5:: eine schematische Darstellung einer Bremse.

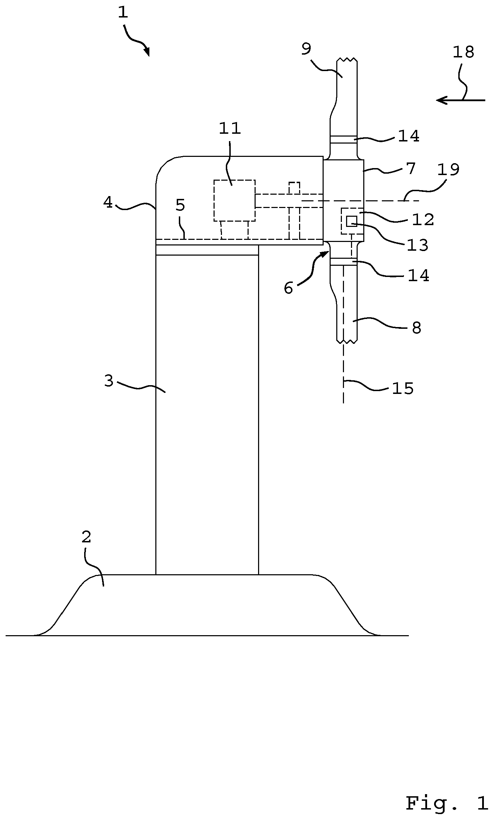

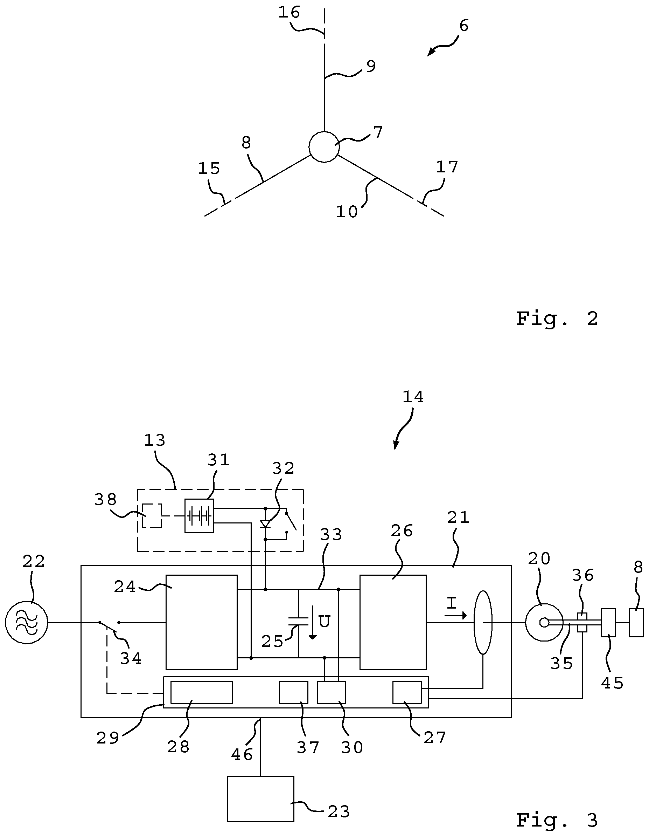

Aus Fig. 1 ist eine schematische Darstellung einer Windkraftanlage 1 ersichtlich, die einen auf einem Fundament 2 aufstehenden Turm 3 umfasst, an dessen dem Fundament 2 abgewandten Ende ein Maschinenhaus 4 angeordnet ist. Das Maschinenhaus 4 weist eine Halterung (Träger) 5 auf, an der ein Rotor 6 drehbar gelagert ist, der eine Rotornabe 7 und mehrere mit dieser verbundene Rotorblätter 8, 9 und 10 umfasst (siehe auch Fig. 2). Der Rotor 6 ist mechanisch mit einem elektrischen Generator 11 gekoppelt, der in dem Maschinenhaus 4 angeordnet und an dem Träger 5 befestigt ist.

In dem Rotor 6 ist ein Blattwinkelverstellsystem 12 angeordnet, welches Notstromversorgungseinrichtungen 13 umfassende Blattwinkelverstellantriebe 14 gemäß einer Ausführungsform der Erfindung aufweist, mittels welchen die Rotorblätter 8, 9 und 10 um ihre jeweilige Längsachse (Rotorblattachse) 15, 16 bzw. 17 relativ zur Rotornabe 7 gedreht werden können (siehe auch Fig. 2). Jedem der Rotorblätter ist bevorzugt einer der Blattwinkelverstellantriebe 14 zugeordnet. Der Rotor 6 kann durch Windkraft 18 um eine Rotorachse 19 gedreht werden.

Fig. 2 zeigt eine schematische Draufsicht auf den Rotor 6, sodass die drei Rotorblätter 8, 9 und 10 ersichtlich sind. Alternativ können auch lediglich zwei oder mehr als drei Rotorblätter vorgesehen sein.

In Fig. 3 ist ein schematisches Blockschaltbild eines der Blattwinkelverstellantriebe 14 mit zugehöriger Notstromversorgungseinrichtung 13 dargestellt, wobei ein Elektromotor 20 elektrisch mit einem Umrichter 21 gekoppelt ist, der mit einem elektrischen Versorgungsnetz 22 verbunden ist und aus diesem gespeist wird. Ferner ist der Umrichter 21 mit einer Steuerung 23 verbunden, mittels welcher der Umrichter 21 gesteuert wird. Der Umrichter 21 umfasst einen Gleichrichter 24, einen Zwischenkreis 33 mit Kondensator 25 und eine Ausgangsstufe 26. Der Motor 20 ist unter Zwischenschaltung eines Getriebes 45 mechanisch mit dem Rotorblatt 8 gekoppelt, welches mittels des Motors 20 um die Rotorblattachse 15 drehbar ist.

Der dem Motor 20 von der Ausgangsstufe 26 des Umrichters 21 zugeführte Motorstrom I wird mittels einer Strommesseinrichtung 27 gemessen, die Teil einer einen Digitalrechner 28 umfassenden Steuereinheit 29 des Umrichters 21 ist. Ferner umfasst die Steuereinheit 29 eine Spannungsmesseinrichtung 30, mittels welcher die Zwischenkreisspannung U gemessen wird.

Die Notstromversorgungseinrichtung 13 umfasst einen Energiespeicher 31, der über eine Diode 32 auf den Zwischenkreis 33 geschaltet ist. Die Primär-Energieversorgung 22 ist mit dem Eingang des Gleichrichters 24 unter Zwischenschaltung eines Schalters 34 verbunden, der mittels der Steuereinheit 29 betätigt werden kann. An der Motorwelle 35 des Motors 20 ist eine Bremse 36 vorgesehen, mittels welcher eine Drehung der Motorwelle 35 freigegeben, gebremst und verhindert werden kann, wobei letzteres einem Blockieren des Motors 20 entspricht. Die Bremse 36 wird mittels der Steuereinheit 29 gesteuert.

Im Normalbetrieb des Blattwinkelverstellantriebs 14 ist der Schalter 34 geschlossen und die Bremse 36 insbesondere gelöst, sodass der Umrichter 21 von der Primär-Energieversorgung 22 mit elektrischer Energie versorgt wird und den Motor 20 zum Drehen des Rotorblatts 8 um die Blattachse 15 ansteuert. Zur Überprüfung des Energiespeichers 31 wird mittels der Steuereinheit 29 der Schalter 34 geöffnet und der Motor 20 durch die Bremse 36 blockiert, sodass eine Drehung der Motorwelle 35 nicht mehr möglich ist. Ferner entspricht die Zwischenkreisspannung U nun der Spannung des Energiespeichers 31 abzüglich der an der Diode 32 abfallenden Spannung, die in der Regel vernachlässigbar ist. Die Steuereinheit 29 steuert nun die Ausgangsstufe 26 derart an, dass dem Motor 20 ein konstanter Strom I zugeführt wird, der insbesondere kleiner oder gleich dem Nennstrom des Motors 20 ist. Der Energiespeicher 31 wird somit entladen, wobei der blockierte Motor 20 als konstante elektrische Last dient. Der Strom I kann geregelt und/oder konstant gehalten werden, da die Steuereinheit 29 durch die Messeinheit 27 fortlaufend Informationen über den tatsächlich fließenden Strom I erhält und die Ausgangsstufe 26 entsprechend ansteuern kann. Der Steuereinheit 29 steht somit ein den aktuellen Strom I charakterisierendes elektrisches Signal zur Verfügung.

Die Zwischenkreisspannung U wird fortlaufend mittels der Messeinheit 30 erfasst, sodass der Steuereinheit 29 ein die aktuelle Zwischenkreisspannung U charakterisierendes elektrisches Signal zur Verfügung steht. Ferner wird während der Messung der Zwischenkreisspannung U die Zeit mittels einer in die Steuereinheit 29 integrierten Uhr 37 erfasst und steht der Steuereinheit 29 in Form eines elektrischen Signals zur Verfügung. Bevorzugt wird auch während der Messung des Stroms I die Zeit mittels der Uhr 37 erfasst. Ergänzend oder alternativ ist der Motorstrom I in der Steuereinheit 29 als fester Wert hinterlegt, was möglich ist, da der Strom I konstant gehalten wird. Die Steuereinheit 29 verfügt somit über Daten, die den zeitlichen Verlauf der Zwischenkreisspannung U und/oder den Strom I oder dessen zeitlichen Verlauf während der Entladung des Energiespeichers 31 über den blockierten Motor 20 kennzeichnen.

Die Steuereinheit 29 bestimmt auf Basis des zeitlichen Verlaufs der Zwischenkreisspannung U und des Stroms I oder des zeitlichen Verlaufs des Stroms I den Ladezustand des Energiespeichers sowie die in dem Energiespeicher maximal speicherbare Ladungsmenge. Vorzugsweise werden für diese Bestimmung zusätzliche Informationen berücksichtigt, welche durch die Art des Energiespeichers 31 vorgegeben sind. Handelt es sich bei dem Energiespeicher 31 um einen Kondensator, kann auch die elektrische Kapazität des Kondensators durch die Steuereinheit 29 bestimmt werden. Die Steuereinheit 29 bildet somit eine Auswerteeinrichtung zur Auswertung der zur Überprüfung des Energiespeichers 31 gemessenen Spannungs- und/oder Stromwerte. Diese Auswertung liefert eine verlässliche Beschreibung des Zustands des Energiespeichers 31. Das Ergebnis der Auswertung, wie z.B. der Ladezustand des Energiespeichers, die in dem Energiespeicher maximal speicherbare Ladungsmenge und/oder die Kapazität des Kondensators, wird dann an die Steuerung 23 über eine Schnittstelle 46 abgegeben, insbesondere in Form von elektrischen Signalen.

Gemäß einer Abwandlung der Ausführungsform werden die Daten, die den zeitlichen Verlauf der Zwischenkreisspannung U und/oder den Strom I oder dessen zeitlichen Verlauf während der Entladung des Energiespeichers 31 über den blockierten Motor 20 kennzeichnen, über die Schnittstelle 46 an die Steuerung 23 abgegeben. Die Steuerung 23 kann nun auf Basis des zeitlichen Verlaufs der Zwischenkreisspannung U und des Stroms I oder des zeitlichen Verlaufs des Stroms I den Ladezustand des Energiespeichers sowie die in dem Energiespeicher maximal speicherbare Ladungsmenge bestimmen. Vorzugsweise werden für diese Bestimmung zusätzliche Informationen berücksichtigt, welche durch die Art des Energiespeichers 31 vorgegeben sind. Handelt es sich bei dem Energiespeicher 31 um einen Kondensator, kann auch die elektrische Kapazität des Kondensators durch die Steuerung 23 bestimmt werden. Gemäß der Abwandlung bildet die Steuerung 23 die Auswerteeinrichtung zur Auswertung der zur Überprüfung des Energiespeichers 31 gemessenen Spannungs- und/oder Stromwerte.

Die Überprüfung des Energiespeichers 31 kann auf unterschiedliche Weisen beendet werden. Einerseits ist es möglich, die Entladung für eine vorgegebene Zeitdauer durchzuführen. Die Überprüfung endet somit bei Ablauf dieser Zeitdauer. Andererseits ist es möglich, die Überprüfung zu beenden, wenn die Zwischenkreisspannung U kleiner oder gleich einem vorgegebenen Schwellenwert ist. Ferner kann die Überprüfung beendet werden, wenn der Motorstrom I nicht auf dem gewünschten Wert gehalten werden kann und z.B. kleiner oder gleich einem vorgegebenen Schwellenwert ist. Auch ist eine Kombination dieser Kriterien für das Beenden der Überprüfung möglich. Nach dem Beenden der Überprüfung wird der Schalter 34 geschlossen, sodass der Umrichter 21 wieder von der Primär-Energieversorgung 22 mit elektrischer Energie versorgt wird. Ferner kann der Motorstrom I durch entsprechende Ansteuerung der Ausgangsstufe 26 auf einen gewünschten Wert eingestellt werden. Auch kann die Bremse 36 gelöst werden, sodass der Blattwinkelverstellantrieb 14 wieder seinen normalen Betrieb aufnehmen und das Rotorblatt 8 verstellen kann.

Der nach der Überprüfung teilentladene Energiespeicher 31 wird nun entweder über eine schematisch dargestellte Ladeeinrichtung 38 oder über den Zwischenkreis 33 aufgeladen, wobei im letzteren Fall die Diode 32 überbrückt wird.

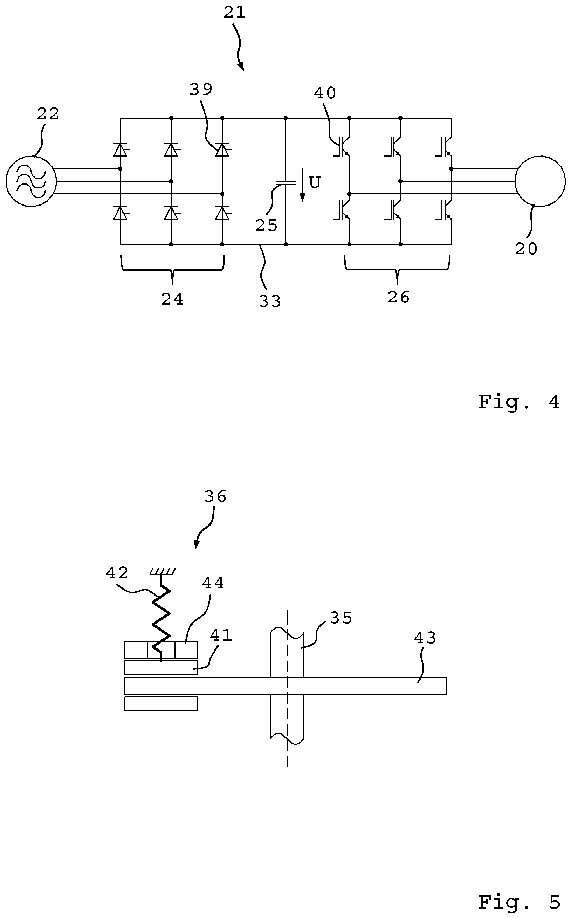

Aus Fig. 4 ist ein schematisches Schaltbild des Umrichters 21 ersichtlich, wobei der Gleichrichter 24 sechs Thyristoren 39 umfasst und somit als aktivierbarer Gleichrichter ausgebildet ist. Die Gate-Anschlüsse der Thyristoren 39 werden mittels der Steuereinheit 29 angesteuert, sodass mittels dieser ein Aktivieren und ein Deaktivieren des Gleichrichters 24 möglich ist. Werden die Thyristoren 39 nicht gezündet, so ist der Zwischenkreis 33 von der Primär-Energieversorgung 22 elektrisch entkoppelt. In diesem Fall kann der Schalter 34 entfallen.

Die Ausgangsstufe 26 ist als Transistorausgangsstufe ausgebildet und weist sechs IGBTs 40 auf, deren Gate-Anschlüsse mittels der Steuereinheit 29 angesteuert werden. Somit ist der dem Motor 20 zugeführte Motorstrom mittels der Ausgangsstufe 26 und der Steuereinheit 29 steuerbar.

Aus Fig. 5 ist eine schematische Darstellung der Bremse 36 ersichtlich, die ein Reibelement 41 umfasst, welches mittels einer Feder 42 gegen eine mit der Motorwelle 35 drehfest verbunde Bremsscheibe 43 gedrückt werden kann. Ferner ist ein Elektromagnet 44 vorgesehen, mittels welchem das zumindest teilweise aus Magnetwerkstoff bestehende Reibelement 41 von der Bremsscheibe 43 abgerückt werden kann. Die Kraft der Feder 42 ist groß genug, dass sie im stromlosen Zustand des Elektromagneten 44 das Reibelement 41 derart stark gegen die Bremsscheibe 43 drückt, dass eine Drehung der Motorwelle 35 verhindert wird und somit der Motor 20 blockiert ist.

### Bezugszeichenliste

1 Windkraftanlage
2 Fundament
3 Turm
4 Maschinenhaus
5 Träger / Halterung
6 Rotor
7 Rotornabe
8 Rotorblatt
9 Rotorblatt
10 Rotorblatt
11 elektrischer Generator
12 Blattwinkelverstellsystem
13 Notstromversorgungseinrichtung
14 Blattwinkelverstellantrieb
15 Rotorblattachse
16 Rotorblattachse
17 Rotorblattachse
18 Wind
19 Rotorachse
20 Elektromotor
21 Umrichter
22 elektrisches Netz, vorzugsweise Wechselstromnetz
23 Steuerung
24 Gleichrichter
25 Zwischenkreiskondensator
26 Ausgangsstufe
27 Strommesseinrichtung
28 Digitalrechner
29 Steuereinheit
30 Spannungsmesseinrichtung
31 Energiespeicher
32 Diode
33 Zwischenkreis
34 Schalter
35 Motorwelle
36 Bremse
37 Uhr
38 Ladeeinrichtung
39 Thyristoren
40 IGBT
41 Reibelement
42 Feder
43 Bremsscheibe
44 Elektromagnet
45 Getriebe
46 Schnittstelle
U Zwischenkreisspannung
I Motorstrom

## Patentansprüche

1. Verfahren zum Überprüfen eines elektrischen Energiespeichers (31) für einen Blattwinkelverstellantrieb (14) einer Windkraftanlage (1), der einen Umrichter (21), wenigstens einen von dem Umrichter (21) gespeisten Elektromotor (20) und den Energiespeicher (31) umfasst, wobei der Elektromotor (20) blockiert wird, der Energiespeicher (31) über den Umrichter (21) mit dem blockierten Elektromotor (20) belastet wird und die Entladung des so belasteten Energiespeichers (31) beobachtet wird, **dadurch gekennzeichnet, dass** der Motorstrom (I) während der Belastung des Energiespeichers (31) von dem Umrichter (21) kleiner oder gleich einem Schwellenwert gehalten wird, der dem Nennstrom des Elektromotors (31) entspricht.

2. Verfahren nach Anspruch 1, **dadurch gekennzeichnet, dass** der Elektromotor (20) als Wechselstrommotor ausgebildet ist.

3. Verfahren nach Anspruch 1 oder 2,
**dadurch gekennzeichnet, dass**
der Energiespeicher (31) während der Belastung elektrisch auf einen Zwischenkreis (33) des Umrichters (21) geschaltet ist.

4. Verfahren nach Anspruch 3,
**dadurch gekennzeichnet, dass**
der Zwischenkreis (33) vor oder zu Beginn der Belastung des Energiespeichers (31) von einer Primär-Energieversorgung (22) elektrisch getrennt wird und während der Belastung von der Primär-Energieversorgung (22) elektrisch getrennt ist.

5. Verfahren nach einem der vorangehenden Ansprüche,
**dadurch gekennzeichnet, dass**
das Beobachten der Entladung des Energiespeichers (31) das Messen des elektrischen Motorstroms (I) umfasst.

6. Verfahren nach einem der vorangehenden Ansprüche,
**dadurch gekennzeichnet, dass**
der elektrische Motorstrom (I) während der Belastung des Energiespeichers (31) von dem Umrichter (21) gesteuert oder geregelt wird.

7. Verfahren nach einem der vorangehenden Ansprüche,
**dadurch gekennzeichnet, dass**
das Beobachten der Entladung des Energiespeichers (31) das Messen der Zwischenkreisspannung (U) umfasst.

8. Verfahren nach einem der vorangehenden Ansprüche,
**dadurch gekennzeichnet, dass**
auf Basis der Beobachtung der Entladung des Energiespeichers (31) die speicherbare Ladungsmenge des Energiespeichers (31) und/oder der Ladezustand des Energiespeichers (31) bestimmt wird.

9. Verfahren nach einem der vorangehenden Ansprüche,
**dadurch gekennzeichnet, dass**
der Energiespeicher (21) wenigstens einen Akkumulator umfasst oder durch diesen gebildet ist.

10. Verfahren nach einem der vorangehenden Ansprüche,
**dadurch gekennzeichnet, dass**
der Energiespeicher (31) wenigstens einen Kondensator umfasst oder durch diesen gebildet ist.

11. Verfahren nach Anspruch 10,
**dadurch gekennzeichnet, dass**
auf Basis der Beobachtung der Entladung des Energiespeichers (31) die elektrische Kapazität des Kondensators bestimmt wird.

12. Verfahren nach einem der vorangehenden Ansprüche,
**dadurch gekennzeichnet, dass**
die Belastung des Energiespeichers (31) mit dem blockierten Elektromotor (20) vorübergehend erfolgt und anschließend die Blockade des Elektromotors (20) aufgehoben wird.

13. Blattwinkelverstellantrieb für eine Windkraftanlage (1), mit einem einen Gleichspannungszwischenkreis (33) aufweisenden Umrichter (21), der elektrisch von einer Primär-Energieversorgung (22) gespeist wird oder werden kann, wenigstens einem mit dem Umrichter (21) elektrisch gekoppelten Elektromotor (20), der von dem Umrichter (21) mit elektrischer Energie versorgt wird oder werden kann, einem Energiespeicher (31), von welchem der Elektromotor (20) bei Ausfall der Primär-Energieversorgung (22) elektrisch gespeist wird oder werden kann, wobei der Elektromotor (20) mittels einer Bremse (36) blockiert wird oder werden kann, der Zwischenkreis (33) von der Primär-Energieversorgung (22) elektrisch getrennt wird oder werden kann, bei getrennter Primär-Energieversorgung (22) der Energiespeicher (31) über den Umrichter (21) mit dem durch die Bremse (36) blockierten Elektromotor (20) elektrisch belastet wird oder werden kann, die Entladung des mit dem blockierten Elektromotor (20) belasteten Energiespeichers (31) beobachtet wird oder werden kann, **dadurch gekennzeichnet, dass** der Blattwinkelverstellantrieb dazu angepasst ist, den Motorstrom (I) während der Belastung des Energiespeichers (31) von dem Umrichter (21) kleiner oder gleich einem Schwellenwert zu halten, der dem Nennstrom des Elektromotors (31) entspricht.

14. Blattwinkelverstellantrieb nach Anspruch 13, **dadurch gekennzeichnet, dass** der Elektromotor (20) als Wechselstrommotor ausgebildet ist.

15. Blattwinkelverstellantrieb nach Anspruch 13 oder 14,
**dadurch gekennzeichnet, dass**
der Energiespeicher (31) elektrisch auf den Zwischenkreis (31) geschaltet oder schaltbar ist.

16. Blattwinkelverstellantrieb nach einem der Ansprüche 13 bis 15,
**dadurch gekennzeichnet, dass**
mittels einer oder der Steuereinheit (29)
die Bremse (36) betätigt wird oder werden kann,
die Primär-Energieversorgung (22) elektrisch von dem Zwischenkreis (33) entkoppelt wird oder werden kann,
die Entladung des mit dem blockierten Elektromotor (20) belasteten Energiespeichers (31) beobachtet wird oder werden kann.

17. Blattwinkelverstellantrieb nach Anspruch 16,
**dadurch gekennzeichnet, dass**
die Steuereinheit (29) eine Strommesseinrichtung (27), mittels welcher der Motorstrom (I) gemessen wird oder werden kann, und eine Spannungsmesseinrichtung (30) aufweist, mittels welcher die Zwischenkreisspannung (U) gemessen wird oder werden kann.

## Claims

1. Method for checking an electric energy storage device (31) for a pitch-control drive (14) of a wind turbine (1), which comprises a converter (21), at least one electric motor (20), which is fed by the converter (21), and the energy storage device (31), wherein the electric motor (20) is blocked, the energy storage device (31) is loaded with the blocked electric motor (20) via the converter (20) and the discharging of the energy storage device (31) loaded in this way is monitored, **characterised in that** the motor current (I) during loading of the energy storage device (31) by the converter (21) is kept less than or equal to a threshold value which corresponds to the rated current of the electric motor (31).

2. Method according to Claim 1, **characterised in that** the electric motor (20) is designed as an alternating current motor.

3. Method according to Claim 1 or 2, **characterised in that** the energy storage device (31) is electrically connected to an intermediate circuit (33) of the converter (21) during loading.

4. Method according to Claim 3, **characterised in that** the intermediate circuit (33) is electrically separated from a primary energy supply (22) before or at the beginning of loading of the energy storage device (31) and is electrically separated from the primary energy source (22) during loading.

5. Method according to any one of the preceding claims, **characterised in that** monitoring the discharge of the energy storage device (31) comprises measuring the electric motor current(I).

6. Method according to any one of the preceding claims, **characterised in that** the electric motor current (I) is controlled or regulated by the converter (21) during loading of the energy storage device (31).

7. Method according to any one of the preceding claims, **characterised in that** monitoring the discharge of the energy storage device (31) comprises measuring the intermediate circuit voltage (U).

8. Method according to any one of the preceding claims, **characterised in that** the storable charge quantity of the energy storage device (31) and/or the charge state of the energy storage device (31) is determined based on the monitoring of the discharge of the energy storage device (31) .

9. Method according to any one of the preceding claims, **characterised in that** the energy storage device (21) *[sic: 31]* comprises at least one accumulator or is formed by this.

10. Method according to any one of the preceding claims, **characterised in that** the energy storage device (31) comprises at least one capacitor or is formed by this.

11. Method according to Claim 10, **characterised in that** the electrical capacity of the capacitor is determined based on the monitoring of the discharge of the energy storage device (31).

12. Method according to any one of the preceding claims, **characterised in that** loading of the energy storage device (31) with the blocked electric motor (20) takes place temporarily and the blocking of the electric motor (20) is subsequently lifted.

13. Pitch control drive for a wind turbine (1), having a converter (21), which has a direct-voltage intermediate circuit (33) and which is or can be electrically fed from a primary energy supply (22), at least one electric motor (20), which is electrically coupled to the converter (21) and which is or can be supplied with electrical energy by the converter (21), an energy storage device (31), from which the electric motor (20) is or can be electrically fed when the primary energy supply (22) fails, wherein the electric motor (20) is or can be blocked by means of a brake (36), the intermediate circuit (33) is or can be separated from the primary energy supply (22), when the primary energy supply (22) has been separated the energy storage device (31) is or can be electrically loaded via the converter (21) with the electric motor (20) blocked by the brake (36), the discharging of the energy storage device (31) loaded with the blocked electric motor (20) is or can be monitored, **characterised in that** the pitch control drive is adapted to keep the motor current (I) less than or equal to a threshold value which corresponds to the rated current of the electric motor (20) during loading of the energy storage device (31) by the converter (21) .

14. Pitch control drive according to Claim 13, **characterised in that** the electric motor (20) is designed as an alternating current motor.

15. Pitch control drive according to Claim 13 or 14, **characterised in that** the energy storage device (31) is electrically connected or can be electrically connected to the intermediate circuit (31) *[sic: 33].*

16. Pitch control drive according to any one of Claims 13 to 15, **characterised in that** by means of a or the control unit (29) the brake (36) is or can be operated, the primary energy supply (22) is or can be electrically decoupled from the intermediate circuit (33) and the discharge of the energy storage device (31) loaded with the blocked electric motor (20) is or can be monitored.

17. Pitch control drive according to Claim 16, **characterised in that** the control unit (29) has a current measuring device (27), by means of which the motor current (I) is or can be measured, and a voltage measuring device (30), by means of which the intermediate circuit voltage (U) is or can be measured.

## Revendications

1. Procédé de vérification d'un accumulateur d'énergie électrique (31) pour un entraînement de réglage du pas (14) d'une éolienne (1), qui comprend un onduleur (21), au moins un moteur électrique (20) alimenté par l'onduleur (21) et l'accumulateur d'énergie (31), le moteur électrique (20) étant bloqué, l'accumulateur d'énergie (31) étant sollicité par l'intermédiaire de l'onduleur (21) par le moteur électrique bloqué (20) et la décharge de l'accumulateur d'énergie (31) ainsi sollicité étant observée, **caractérisé en ce que** le courant du moteur (I) est maintenu, pendant la sollicitation de l'accumulateur d'énergie (31) par l'onduleur (21), inférieur ou égal à une valeur seuil, qui correspond au courant nominal du moteur électrique (31).

2. Procédé selon la revendication 1, **caractérisé en ce que** le moteur électrique (20) est conçu comme un moteur à courant alternatif.

3. Procédé selon la revendication 1 ou 2,
**caractérisé en ce que**
l'accumulateur d'énergie (31) est commuté électriquement, pendant la sollicitation, sur un circuit intermédiaire (33) de l'onduleur (21).

4. Procédé selon la revendication 3,
**caractérisé en ce que**
le circuit intermédiaire (33) est déconnecté électriquement d'une alimentation d'énergie primaire (22) avant ou au début de la sollicitation de l'accumulateur d'énergie (31) et est déconnecté électriquement de l'alimentation en énergie primaire (22) pendant la sollicitation.

5. Procédé selon l'une des revendications précédentes,
**caractérisé en ce que**
l'observation de la décharge de l'accumulateur d'énergie (31) comprend la mesure du courant de moteur électrique (I).

6. Procédé selon l'une des revendications précédentes,
**caractérisé en ce que**
le courant de moteur électrique (I) est contrôlé ou régulé pendant la sollicitation de l'accumulateur d'énergie (31) par l'onduleur (21).

7. Procédé selon l'une des revendications précédentes,
**caractérisé en ce que**
l'observation de la décharge de l'accumulateur d'énergie (31) comprend la mesure de la tension du circuit intermédiaire (U).

8. Procédé selon l'une des revendications précédentes,
**caractérisé en ce que**
la quantité de charge pouvant être accumulée par l'accumulateur d'énergie (31) et/ou l'état de charge de l'accumulateur d'énergie (31) est déterminé sur la base de l'observation de la décharge de l'accumulateur d'énergie (31).

9. Procédé selon l'une des revendications précédentes,
**caractérisé en ce que**
l'accumulateur d'énergie (21) comprend au moins un accumulateur ou est constitué de celui-ci.

10. Procédé selon l'une des revendications précédentes,
**caractérisé en ce que**
l'accumulateur d'énergie (31) comprend au moins un condensateur ou est constitué de celui-ci.

11. Procédé selon la revendication 10,
**caractérisé en ce que**
la capacité électrique du condensateur est déterminée sur la base de l'observation de la décharge de l'accumulateur d'énergie (31).

12. Procédé selon l'une des revendications précédentes,
**caractérisé en ce que**
la sollicitation de l'accumulateur d'énergie (31) par le moteur électrique (20) bloqué a lieu provisoirement puis que le blocage du moteur électrique (20) est supprimé.

13. Entraînement de réglage de pas pour une éolienne (1), avec un onduleur (21) comprenant un circuit intermédiaire à tension continue (33), qui est ou peut être alimenté électriquement par une alimentation en énergie primaire (22), au moins un moteur électrique (20) couplé électriquement avec l'onduleur (21), qui est ou peut être alimenté en énergie électrique par l'onduleur (21), un accumulateur d'énergie (31), par l'intermédiaire duquel le moteur électrique (20) est ou peut être alimenté électriquement lors d'une panne de l'alimentation en énergie primaire (22), le moteur électrique (20) étant ou pouvant être bloqué au moyen d'un frein (36), le circuit intermédiaire (33) étant ou pouvant être déconnecté électriquement de l'alimentation en énergie primaire (22), lorsque l'alimentation en énergie primaire (22) est déconnectée, l'accumulateur d'énergie (31) étant ou pouvant être sollicité électriquement par l'intermédiaire de l'onduleur (21) par le moteur électrique (20) bloqué au moyen du frein (36), la décharge de l'accumulateur d'énergie (31) sollicité par le moteur électrique (20) bloqué étant ou pouvant être observée, **caractérisé en ce que** l'entraînement de réglage de pas est conçu pour maintenir le courant de moteur (I), pendant la sollicitation de l'accumulateur d'énergie (31) par l'onduleur (21), inférieur ou égal à une valeur seuil, qui correspond au courant nominal du moteur électrique (31).

14. Entraînement de réglage de pas selon la revendication 13, **caractérisé en ce que** le moteur électrique (20) est conçu comme un moteur à courant alternatif.

15. Entraînement de réglage de pas selon la revendication 13 ou 14, **caractérisé en ce que** l'accumulateur d'énergie (31) est ou peut être commuté électriquement sur le circuit intermédiaire (31).

16. Entraînement de réglage de pas selon l'une des revendications 13 à 15,
**caractérisé en ce que**
au moyen d'une ou de l'unité de commande (29), le frein (36) est ou peut être actionné, l'alimentation en énergie primaire (22) est ou peut être découplée électriquement du circuit intermédiaire (33), la décharge de l'accumulateur d'énergie (31) sollicité par le moteur électrique (20) bloqué est ou peut être observée.

17. Entraînement de réglage de pas selon la revendication 16,
**caractérisé en ce que**
l'unité de commande (29) comprend un dispositif de mesure de courant (27), au moyen duquel le courant de moteur (I) est ou peut être mesuré, et un dispositif de mesure de tension (30), au moyen duquel la tension du circuit intermédiaire (U) est ou peut être mesurée.
